(19) Europäisches Patentamt
European Patent Office
Office européen des brevets

(11) EP 3 007 177 A1

(12) # EUROPEAN PATENT APPLICATION

(43) Date of publication:
**13.04.2016 Bulletin 2016/15**

(21) Application number: **15188104.2**

(22) Date of filing: **02.10.2015**

(51) Int Cl.:
***H01B 3/28*** *(2006.01)* ***C08L 23/16*** *(2006.01)*
***H01B 3/44*** *(2006.01)* ***C08K 3/34*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **10.10.2014 US 201414511217**

(71) Applicant: **General Electric Company**
**Schenectady, NY 12345 (US)**

(72) Inventors:
- **CHEN, Qin**
  **Niskayuna, NY New York 12309 (US)**
- **CALEBRESE, Christopher Michael**
  **Niskayuna, NY New York 12309 (US)**
- **CAO, YANG**
  **Glastonbury, CT Connecticut 06073 (US)**
- **ZHONG, Sheng**
  **Raleigh, NC North Carolina 27606 (US)**

(74) Representative: **Serjeants LLP**
**Dock**
**75 Exploration Drive**
**Leicester, LE4 5NU (GB)**

(54) **A HIGH VOLTAGE DIRECT CURRENT (HVDC) CABLE WITH IMPROVED ELECTRIC FIELD DISTRIBUTION**

(57) A high voltage direct current (HVDC) cable (10) is provided. The cable (10) includes a conductor (12) and an insulation layer (14) disposed inside outer layers (16). The insulation layer (14) includes ethylene-propylene rubber, talc, and montmorillonite.

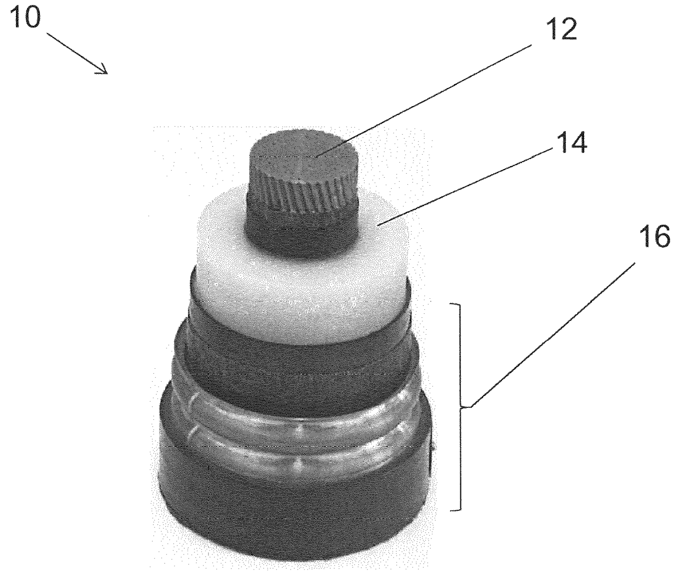


FIG. 1

EP 3 007 177 A1

## Description

GOVERNMENT RIGHTS STATEMENT

This invention was made with government support under contract number DEAR0000231 awarded by the U.S. Department of Energy. The government has certain rights in the invention.

BACKGROUND

High voltage direct current (HVDC) cables are important components of HVDC grids and they account for more than one third of the system cost. Compared to alternating current (AC) cables, there are unique challenges that are specifically related to DC cables, such as nonlinear electric field distribution and the distortion/enhancement of electric fields due to space charge accumulation.

Currently, there are two types of HVDC cables commercially available. One type of cable employs a lapped insulation system, such as oil-paper insulation or mass impregnated paper insulation. These cables are proven to have very good reliability and can operate at very high voltage levels. However, they are expensive because of their complicated structure and they also raise environmental concerns. The other type of HVDC cable includes those with extruded polymer insulation. The state-of-the-art extruded insulation is a special grade of crosslinked polyethylene (XLPE) for HVDC applications, such as the "Superclean" XLPE. This material is different from the generic XLPE insulation used for AC cables. The HVDC XLPE materials are typically special grades of resin with very low amount of defects. The cable manufacture processes employed to make these cables are very tightly controlled to ensure a low defect rate.

In order to try to minimize space charge accumulation, additional prolonged heating steps, which limit throughput, are needed for the state-of-the-art extruded HVDC cables. All the foregoing considerations contribute to the high cost for the currently-available extruded HVDC cables.

Accordingly, a need exists for cables and methods that allow for improved electric field distribution, preferably at reduced costs over the presently-available cables and methods.

BRIEF DESCRIPTION

Briefly, the present invention satisfies the need for improved electrical field distribution in HVDC cables. For example, it has been found that, with the proper selection of resin chemistry, filler type, filler content, and optional surface modification of the filler, a resultant composition and method employing the same allow for suppressed space charge accumulation, and enable HVDC cable solutions with high reliability and low cost.

In one aspect, the invention provides a method for improving the electric field distribution in a high voltage direct current cable. The method includes providing a cable comprising a conductor, a protective jacket, a shield layer disposed inside the jacket, and an insulation layer disposed inside the shield layer, surrounding the conductor, said insulation layer comprising ethylene-propylene rubber, talc, and montmorillonite.

In another aspect, the invention provides a method of making a high voltage direct current cable. The method includes encasing a metal conductor within an insulation layer which, as described above, comprises ethylene-propylene rubber, talc, and montmorillonite.

In another aspect, the invention provides a HVDC cable.

In another aspect, the invention provides a grid system comprising the inventive HVDC cable.

DRAWINGS

The present invention will hereinafter be described in conjunction with the following drawing figures, which are not necessarily drawn to scale, and wherein like numerals denote like elements.

FIG. 1 depicts a portion of an embodiment of an HVDC cable according to the present invention.

FIG. 2 is a simplified representation of an HVDC cable according to the present invention.

FIG. 3A depicts space charge accumulation for a Superclean DC XLPE comparative example.

FIG. 3B depicts space charge accumulation for an ethylene-propylene rubber (EPR) used in an embodiment of the inventive insulation layer.

FIGS. 4A-C show electric field distribution results for Superclean DC XLPE, a nanoclay-EPR embodiment, and a

second nanoclay-EPR embodiment, respectively.

DETAILED DESCRIPTION

Aspects of the present invention and certain features, advantages, and details thereof, are explained more fully below with reference to the non-limiting embodiments illustrated in the accompanying drawings. Descriptions of well-known materials, fabrication tools, processing techniques, etc., are omitted so as to not unnecessarily obscure the invention in detail. It should be understood, however, that the detailed description and the specific examples, while indicating embodiments of the invention, are given by way of illustration only, and are not by way of limitation. Various substitutions, modifications, additions and/or arrangements within the spirit and/or scope of the underlying inventive concepts will be apparent to those skilled in the art from this disclosure.

The presently disclosed HVDC cables and methods address the problems of space charge accumulation, undesirable electric field enhancement in HVDC applications, and/or excessive costs associated with known HVDC cables and methods.

The invention addresses the problems in the art by introducing a new type of HVDC extruded cable insulation. Advantageous space charge performance is achieved by adding special fillers during the cable manufacturing processes, which specifically optimize DC cable performance while simultaneously avoiding the additional costs associated with XLPE DC cables due to, e.g., special resin grade, special manufacturing processes, and post-manufacturing treatments. Thus, the present invention offers novel DC cables and processes that improve performance and can significantly reduce the cost of HVDC systems, thereby helping to promote HVDC adoption, and to achieve higher grid efficiency and flexibility.

Unlike the state-of-the-art XLPE insulation which relies on resins with ultrahigh purity, embodiments of the presently disclosed methods, nanoclay-reinforced ethylene-propylene rubber (EPR) cables are formed by intentionally adding fillers with the proper characteristics, which also advantageously provides for a much wider array of options when optimizing the properties of insulation.

In one aspect, the invention provides a method for improving the electric field distribution in a high voltage direct current cable. The method includes providing a cable comprising a conductor, a protective jacket, a shield layer disposed inside the jacket, and an insulation layer disposed inside the shield layer, surrounding the conductor, said insulation layer comprising ethylene-propylene rubber, talc, and montmorillonite. The invention also provides the described cable.

FIG. 1 depicts a portion of an embodiment of an HVDC cable 10 according to compositions and methods of the present invention. The HVDC cable 10 includes, inter alia, conductor 12, insulation layer 14, and outer layers 16, which include a protective jacket and a shield layer disposed inside the jacket, surrounding the insulation layer 14. FIG. 2 is a simplified representation of HVDC cable 10. Other cable assemblies are known in the art (see, e.g., U.S. Patent No. 8,308,506) and are encompassed by the present invention.

In some embodiments, any and/or all additives (e.g., rubber, talc, and/or montmorillonite) are homogenously dispersed within the ethylene-propylene rubber.

Persons having ordinary skill in the art are away of how to obtain ethylene propylene rubber. In some embodiments, ethylene-propylene (EP) base polymer is obtained by copolymerizing ethylene and propylene via the Ziegler-Natta process. The resulting blocky copolymer is termed ethylene-propylene rubber (EPR) due to its rubbery characteristics. A variation of EP includes a diene monomer, at the level of 3-7% by weight, forming a terpolymer labeled as ethylene-propylene-diene (EPDM). As used herein, the terms "ethylene-propylene rubber" (used interchangeably with "EPR") is intended to encompass both EP and EPDM. In various embodiments, EPR comprises one or more additional components such as processing aids and ingredients to fulfill various functional and physical requirements. Table 1 provides a non-exhaustive list of commercially available EPRs that may be used in the present invention, together with a summary of their respective properties. In Table 1, ENB is Ethylidene Norbornene, a type of diene.

TABLE 1

| Material | Ethylene (%) | Propylene (%) | Reported Crystallinity (%) | ENB (%) | Ash | Volatiles | Molecular Weight Distribution | Mooney Visc (125 C) |
|---|---|---|---|---|---|---|---|---|
| Nordel | 70.0 | 29.5 | 12 | 0.5 | <0.1 | <0.4 % | Narrow | 45 |
| Nordel | 70.5 | 29.0 | 15 | 0.5 | <0.1 | <0.4 % | Medium | 20 |
| Nordel | 69.0 | 30.5 | 14 | 0.5 | <0.1 | <0.4 % | Medium | 20 |
| Vistalon | 69.0 | 28.2 | | 2.8 | | | | 60 |
| Vistalon | 73.0 | 22.0 | | 5.0 | | | | 60 |

(continued)

| Material | Ethylene (%) | Propylene (%) | Reported Crystallinity (%) | ENB (%) | Ash | Volatiles | Molecular Weight Distribution | Mooney Visc (125 C) |
|---|---|---|---|---|---|---|---|---|
| Vistalon | 72.0 | 28.0 | | 0 | | | | 17 |
| Vistalon | 77.0 | 23.0 | | 0 | | | | 25 |
| Vistalon | 76.0 | 20.7 | | 3.3 | | | | 24 |
| Vistalon | 57.5 | 37.8 | | 4.7 | | | | 25 |

In some embodiments, the inventive method comprises transmitting high voltage direct current through the cable. The targeted voltage rating ranges from 10 kV to 600 kV. The service life is typically expected to be greater than 25 years. There are mainly two types of HVDC systems, namely, those with line commutated converters (LCC) and those with voltage sourced converters (VSC). In LCC systems, the polarity of voltage needs to be reversed if the direction of power flow needs to be changed. In VSC systems, the voltage is maintained at the same polarity. Correspondingly, the cable insulation in the LCC systems must be able to withstand the voltage polarity reversal, while those in the VSC systems do not necessarily need to satisfy this requirement. HVDC transmission is well within the knowledge of persons having ordinary skill in the art.

In some embodiments, the montmorillonite (MMT) in the insulation layer comprises MMT that has been modified with a quaternary ammonium compound. For example, in some embodiments, the MMT comprises at least one of (i) MMT modified with dimethyl, benzyl, hydrogenated tallow, quaternary ammonium (e.g., commercially available as Cloisite 10A, sold by BYK Additives & Instruments); and (ii) MMT modified with dimethyl, dehydrogenated tallow, quaternary ammonium (e.g., commercially available as Cloisite 20A, sold by BYK Additives & Instruments).

Typical properties of Cloisite 10A and Cloisite 20A are as follows:

Cloisite 10A:

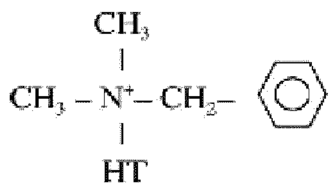

Where HT is Hydrogenated Tallow (~65% C18; ~30% C16; ~5% C14)

***Anion: Chloride***

Typical properties:

| Treatment/Properties: | Organic Modifier (1) | Modifier Concentration | % Moisture | % Weight Loss on Ignition |
|---|---|---|---|---|
| Cloisite® 10A | 2MBHT | 125 meq/100g clay | < 2% | 39% |
| (1) 2MBHT: dimethyl, benzyl, hydrogenated tallow, quaternary ammonium | | | | |

Typical dry particle sizes: (microns, by volume)

| 10% less than: | 50% less than: | 90% less than: |
|---|---|---|
| 2μm | 6μm | 13μm |

Density:

| Loose Bulk, lbs/ft$^3$ | Packed Bulk, lbs/ft$^3$ | Density, g/cc |
|---|---|---|
| 10.21 | 16.52 | 1.90 |

Cloisite 20A:

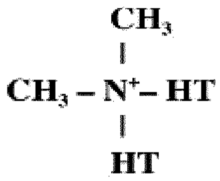

Where HT is Hydrogenated Tallow (~65% C18; ~30% C16; ~5% C14)

***Anion: Chloride***

Typical properties:

| Treatment/Properties: | Organic Modifier (1) | Modifier Concentration | % Moisture | % Weight Loss on Ignition |
|---|---|---|---|---|
| Cloisite® 20A | 2M2HT | 95 meq/100g clay | < 2% | 38% |
| (1) 2M2HT: dimethyl, dehydrogenated tallow, quaternary ammonium | | | | |

Typical dry particle sizes: (microns, by volume)

| 10% less than: | 50% less than: | 90% less than: |
|---|---|---|
| 2μ | 6μ | 13μ |

Density:

| Loose Bulk, lbs/ft$^3$ | Packed Bulk, lbs/ft$^3$ | Density, g/cc |
|---|---|---|
| 7.35 | 13.55 | 1.77 |

The MMT may be comprised within a wide variety of commercially available natural and organically modified clays. Commercially available organically modified clays are available from, e.g., BYK Additives & Instruments (Cloisite clays) and Nanocor (Nanomer clays). A listing of some non-exclusive available offerings, along with select clay properties provided by the manufacturer, are shown in Tables 2 and 3.

TABLE 2 - Commercially available MMT type clays from BYK Additives & Instruments

| Cloisite Clay Type | Ignition wt loss (%) | Spacing (Å) | Particle Size (μm) | Interlayer Cation |
|---|---|---|---|---|
| 10A | 39 | 19.2 | 2-13 | 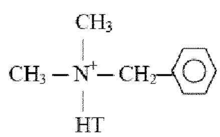 |

(continued)

| Cloisite Clay Type | Ignition wt loss (%) | Spacing (Å) | Particle Size (μm) | Interlayer Cation |
|---|---|---|---|---|
| 11B | 32 | 18.4 | 37 | 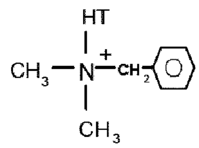 |
| 15A | 43 | 31.5 | 2-13 | 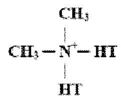 |
| 20A | 38 | 24.2 | 2-13 | 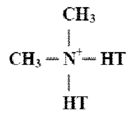 |
| 30B | 30 | 18.5 | 2-13 | 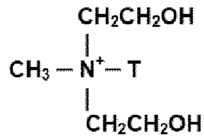 |
| 93A | 39.5 | 23.6 | 2-13 | 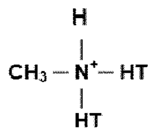 |
| Ca++ | 7 | 15.5 | 2-25 | $Ca^{++}$ |
| Nanofil 116 | 8 | 12.5 | 12 | $Na^{+}$ |
| T and HT stand for tallow and hydrogenated tallow. | | | | |

TABLE 3 - Commercially available MMT type clays from Nanocor

| Nanomer clay type | Modifer content (%) | Size(μm) | Interlayer Cation/Modifier |
|---|---|---|---|
| PGW | -- | | Inorganic (not specified) |
| PVG | -- | | Inorganic (not specified) |
| PGN | -- | | Inorganic (not specified) |
| L28E | 25-30% | <20 | 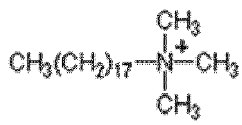 |
| I.30E | 25-30 | < 20 | 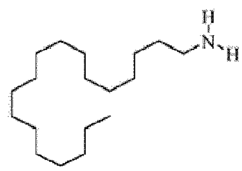 |
| I.44P | 35-45 | <20 | 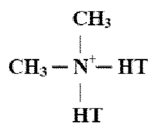 |

(continued)

| Nanomer clay type | Modifer content (%) | Size(μm) | Interlayer Cation/Modifier |
|---|---|---|---|
| I.31PS | 15-35 | <20 | 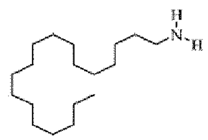 (Clay is also silane treated) |
| I.34TCN (I.34MN) | 25-30 | <20 | 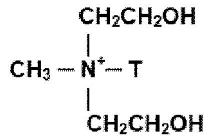 |
| T and HT stand for tallow and hydrogenated tallow. | | | |

In some embodiments, the MMT present in the insulation layer has an average particle size of about 10 nm to about 1 mm (for example, 10, 50, 100, 150, 200, 250, 300, 350, 400, 450, 500, 550, 600, 650, 700, 750, 800, 850, 900, 950, 1000, 1500, 2000, 2500, 3000, 3500, 4000, 4500, 5000, 5500, 6000, 6500, 7000, 7500, 8000, 8500, 9000, 9500, 10000, 10500, 11000, 11500, 12000, 12500, 13000, 13500, 14000, 14500, 15000, 15500, 16000, 16500, 17000, 17500, 18000, 18500, 19000, 19500, 20000, 30000, 40000, 50000, 60000, 70000, 80000, 90000, 100000, 200000, 300000, 400000, 500000, 600000, 700000, 800000, 900000, or 1000000 nm), including any and all ranges and subranges therein (e.g., 100 nm to 500 μm).

In some embodiments, the insulation layer comprises about 0.05 phr to about 30 phr (e.g., 0.05, 0.1, 0.2, 0.3, 0.4, 0.5, 0.6, 0.7, 0.8, 0.9, 1, 2, 3, 4, 5, 6, 7, 8, 9, 10, 12, 14, 16, 18, 20, 22, 24, 26, 28, or 30 phr) MMT, including any and all ranges and subranges therein. "Phr" is a known unit, which stands for parts per hundred parts of resin (e.g., for each 100 phr of EPR base polymer, there may be, in some embodiments, about 0.05 phr to about 30 phr MMT). In certain embodiments, the insulation layer comprises about 0.5 phr to about 10 phr MMT.

Talc is a mineral composed of hydrated magnesium silicate. In some embodiments, the talc present in the insulation layer has an average particle size of about 10 nm to about 1 mm (for example, 10, 50, 100, 150, 200, 250, 300, 350, 400, 450, 500, 550, 600, 650, 700, 750, 800, 850, 900, 950, 1000, 1500, 2000, 2500, 3000, 3500, 4000, 4500, 5000, 5500, 6000, 6500, 7000, 7500, 8000, 8500, 9000, 9500, 10000, 10500, 11000, 11500, 12000, 12500, 13000, 13500, 14000, 14500, 15000, 15500, 16000, 16500, 17000, 17500, 18000, 18500, 19000, 19500, 20000, 30000, 40000, 50000, 60000, 70000, 80000, 90000, 100000, 200000, 300000, 400000, 500000, 600000, 700000, 800000, 900000, or 1000000 nm), including any and all ranges and subranges therein (e.g., 100 nm to 500 μm).

In some embodiments, the insulation layer comprises about 1 phr to about 100 phr talc (e.g., 1, 5, 10, 15, 20, 25, 30, 35, 40, 45, 50, 55, 60, 65, 70, 75, 80, 85, 90, 95, or 100 phr), including any and all ranges and subranges therein. In certain embodiments, the insulation layer comprises about 10 phr to about 60 phr talc.

In some embodiments, the insulation layer further comprises a vinyl silane. In non-limiting embodiments, the vinyl silane may be tris (2-methoxyethoxy)(vinyl)silane, dodecyltriethoxysilane, and/or doctadecyltriethoxysilane. In some embodiments, the insulation layer comprises about 0 to about 10 phr (e.g., 0, 1, 2, 3, 4, 5, 6, 7, 8, 9, or 10 phr) vinyl silane. In certain embodiments, the insulation layer comprises less than or equal to about 2 phr vinyl silane. In some embodiments, a silane surface treatment has been applied to the talc in the insulation layer.

In some embodiments, the insulation layer further comprises kaolin (kaolinite aluminiumsilicate) (e.g., Burgess KE).

In some embodiments, the insulation layer further comprises a processing aid. In certain embodiments, the processing aid comprises low density polyethylene (LDPE) and wax. In some embodiments, the processing aid contains from about 0 to about 15 phr wax, and from 0 to about 15 phr of LDPE (e.g., 0, 1, 2, 3, 4, or 5 phr), including any and all ranges and subranges therein.

In some embodiments, the insulation layer comprises one or more of the following additives: crosslinking agent, such as dicumyl peroxide (DCP) (about 0 to about 5 phr); zinc oxide (about 0 to about 10 phr); red lead, i.e., Pb3O4 (about 0 to about 10 phr); antioxidant, such as the Agerite® Resin D® (Polymerized 1,2-dihydro-2,2,4-trimethylquinoline) (about 0 to about 5 phr).

In some embodiments, the insulation layer has a field enhancement factor (FEF), which is a measure of space

charge, calculated as follows: $$FEF = \frac{(\text{max. field}) - (\text{average field})}{(\text{average field})},$$ of less than or equal to about 0.2 (about 20%). For example, in some embodiments, the FEF is about 0 to about 0.5 (i.e., about 0% to about 50%), (e.g., 0, 0.01, 0.02, 0.03, 0.04, 0.05, 0.1, 0.15, 0.2, 0.25, 0.3, 0.35, 0.4, 0.45, or 0.5), including any and all ranges and subranges therein (e.g., 0.1 to 0.2).

In some embodiments, the insulation layer has a relax time of about 0 to about 600 seconds (for example, less than or equal to 600, 550, 500, 500, 450, 400, 350, 300, 250, 200, 150, 120, 110, 100, 90, 80, 70, 60, 50 seconds, etc.), including any and all ranges and subranges therein (e.g., 30 to 101 seconds).

In some embodiments, the insulation layer has a breakdown strength of greater than or equal to about 160kV/mm, and/or resistivity of greater than or equal to about 10 TOhm-m (= about $10^{13}$ Ohm-m) at about 50 °C, and/or temperature coefficient of conductivity less than or equal to about 0.15/°C.

In another aspect, the invention provides a method of making a high voltage direct current cable. The method includes encasing a metal conductor within an insulation layer which, as described above, comprises ethylene-propylene rubber, talc, and montmorillonite.

In another aspect, the invention provides a HVDC cable as described above.

In another aspect, the invention provides a grid system comprising the inventive HVDC cable.

The invention will now be further illustrated, but not limited, by the following examples.

EXAMPLES

EPR Compositions & Properties

Various EPR insulation layer compositions, both in accordance with embodiments of the invention and not (e.g., not comprising both MMT and talc), were prepared and tested. The compositions and their respective properties are summarized in Table 4 below. In the table, MMT refers to montmorillonite; VS refers to vinyl silane (specifically, tris(2-methoxy ethoxy)); Wax refers to a paraffin wax (having a solidification point of 58-60 °C); LDPE refers to low density polyethylene (LDPE); FEF refers to Field Enhancement Factor; Relax Time refers to space charge relaxation time; In general, the electrical conductivity of the insulation layer can be expressed as a function of temperature (T) and electric field (E): $\sigma(T,E) = \sigma_0 \exp(\alpha T + \beta E)$, and Temp. Coefficient refers to the temperature coefficient (a) of conductivity, where (β) is the field coefficient of conductivity, and (τ) is the space charge relaxation time constant (i.e., time constant for the exponential decay of space charge after voltage is turned off), as in the formula $\rho(t) = [\rho(0) - \rho(\infty)] \exp(-\frac{t}{\tau}) + \rho(\infty)$, where p(t) is the space charge density at time t, with t = 0 corresponding to the moment when the voltage is turned off, and t=∞ corresponding to very long time (e.g., t » 100 τ).

TABLE 4

| Ex. # | MMT phr | Talc phr | VS phr | Wax phr | LDPE | MMT type | FEF | Relax Time | Resistivity (50 deg C) | Temp. Coefficient |
|---|---|---|---|---|---|---|---|---|---|---|
| | Optimal property values: | | | | | | <0.2 (20%) | <120 s | >10 TΩ-m | <0.1/°C |
| 1 | 0 | 60 | 2 | 5 | 5 | 10A* | 0.48 | 690 | 330 | 0.02 |
| 2 | 0 | 60 | 0 | 5 | 5 | 10A | 0.34 | 390 | 1000 | 0.07 |
| 3 | 0 | 60 | 2 | 0 | 0 | 10A | 0.23 | 600 | 670 | 0.08 |
| 4 | 0 | 60 | 0 | 0 | 0 | 10A | 0.2 | 10200 | 600 | 0.03 |
| 5 | 5 | 55 | 1 | 2.5 | 2.5 | 10A | 0.167 | 35 | 13.5 | 0.11 |
| 6 | 5 | 55 | 1 | 2.5 | 2.5 | 10A | 0.173 | 35 | 16.7 | 0.11 |
| 7 | 10 | 50 | 2 | 0 | 0 | 10A | 0.11 | 140 | 1 | 0.04 |
| 8 | 10 | 50 | 0 | 5 | 5 | 10A | 0.351 | 70 | 15.7 | 0.13 |
| 9 | 10 | 50 | 0 | 0 | 0 | 10A | 0.13 | 49 | 10.6 | 0.13 |

(continued)

| Ex. # | MMT phr | Talc phr | VS phr | Wax phr | LDPE | MMT type | FEF | Relax Time | Resistivity (50 deg C) | Temp. Coefficient |
|---|---|---|---|---|---|---|---|---|---|---|
| | Optimal property values: | | | | | | <0.2 (20%) | <120 s | >10 TΩ-m | <0.1/°C |
| 10 | 10 | 50 | 2 | 5 | 5 | 10A | 0.37 | 55 | 3.3 | 0.07 |
| 11 | 0 | 60 | 2 | 5 | 5 | 20A** | 0.48 | 690 | 330 | 0.02 |
| 12 | 0 | 60 | 0 | 5 | 5 | 20A | 0.34 | 390 | 1000 | 0.07 |
| 13 | 0 | 60 | 2 | 0 | 0 | 20A | 0.23 | 600 | 670 | 0.08 |
| 14 | 0 | 60 | 0 | 0 | 0 | 20A | 0.2 | 10200 | 600 | 0.03 |
| 15 | 5 | 55 | 1 | 2.5 | 2.5 | 20A | 0.54 | 100 | 17.5 | 0.09 |
| 16 | 5 | 55 | 1 | 2.5 | 2.5 | 20A | 0.43 | 125 | 16.9 | 0.08 |
| 17 | 10 | 50 | 2 | 0 | 0 | 20A | 0.35 | 40 | 2 | 0.08 |
| 18 | 10 | 50 | 0 | 5 | 5 | 20A | 0.51 | 40 | 3.5 | 0.08 |
| 19 | 10 | 50 | 0 | 0 | 0 | 20A | 0.5 | 60 | 6.8 | 0.12 |
| 20 | 10 | 50 | 2 | 5 | 5 | 20A | 0.39 | 70 | 9.97 | 0.11 |
| *10A = Cloisite 10A; **20A = Cloisite 20A | | | | | | | | | | |

Note: in this table, all of the examples include the following additives: 2.5 phr of crosslinking agent DCP; 1.5 phr of antioxidant Agerite® Resin D®; 5 phr of zinc oxide; 4.5 phr of red lead (same for all examples).

Comparative Space Charge Accumulation Testing.

Thin samples of both EPR and "Superclean" XLPE (state-of-the-art DC insulation resin) were subjected to high field (100kV/mm). The results are shown in FIGS. 3A and 3B. FIG. 3A depicts space charge accumulation for the Superclean XLPE example. The peaks 120 represent charges on the electrode and the ridges 122 indicate space charge migration into the insulation. FIG. 3B depicts space charge accumulation for an embodiment of the inventive EPR used in the insulation layer. As shown in FIGS. 3A-B, there is very significant space charge accumulation in the XLPE, but only minimal space charge accumulation in the EPR. The XLPE sample is made from the Borealis Superclean™ LE4253 DC resin. This EPR composition contains: 100 phr of EPR, 60 phr of Kaolin mineral filler, 4.5 phr red lead, 1.5 phr Agerite® Resin D®, 5 phr zinc oxide, 2.5 phr DCP. The thickness of the XLPE sample was 170μm, and the thickness of the EPR sample was 190 μm. The tests were performed under 100kV/mm of electric field, under room temperature. The XLPE sample was fabricated by first melt pressing at 140°C and then crosslinking under 160 °C for 15 minutes. The EPR sample was fabricated by directly melt pressing and crosslink under 160°C for 15 minutes. Both samples were tested as-fabricated and without any further thermal treatment (e.g., degassing under elevated temperature over prolonged time).

Comparative Electric Field Distribution Testing.

Electric field enhancement measurements were performed under typical operating electric fields (20kV/mm) for 12 hours on ~1 mm thick melt-processed samples without any additional treatments. The tests were conducted at room temperature. Compared to the test performed at 100kV/mm, which aims at probing the intrinsic space charge dynamic under very high fields, the 20kV/mm electric field is close to the real operation field in HVDC cables. FIGS. 4A-C show the electric field distribution results for Superclean XLPE, a nanoclay-EPR embodiment, and a second nanoclay-EPR embodiment, respectively. The XLPE sample is made from Borealis SupercleanTM LE4253 DC resin. The Nanoclay-EPR Type 1 formulation composition contains: 100 phr of EPR, 60 phr of Kaolin mineral filler whose surfaces are treated by the doctadecyltriethoxysilane, 4.5 phr red lead, 1.5 phr Agerite® Resin D®, 5 phr zinc oxide, 2.5 phr DCP. The Nanoclay-EPR Type 2 formulation composition contains: 100 phr of EPR, 60 phr of Kaolin mineral filler, 4.5 phr red lead, 1.5 phr Agerite® Resin D®, 5 phr zinc oxide, 2.5 phr DCP, 10 phr wax, and 10 phr LDPE. As shown, there was very significant field enhancement in the XLPE example, and little and moderate field enhancement in the first and second nanoclay-EPR embodiments, respectively. Overall, field enhancement was much more significant in the XLPE than in

the EPR samples. If the XLPE were heated for 5 days at 80 °C then its space charge accumulation would be less, however, such a process is undesirable because it would significantly reduce the manufacturing throughput and increase cost. On the other hand, the EPR samples showed promising space charge behavior without need for heat treatment, and hence provide a low cost solution for high reliability HVDC cables.

Additional Comparative Testing.

Additional comparative testing was done to compare Example A, an EPR formulation used in an insulation layer embodiment of the present invention (which includes MMT and talc), with Example B, a formulation outside of the present invention. The formulations of Examples A and B are presented in Table 5, below.

TABLE 5

| | Example A (phr) | Example B (phr) |
|---|---|---|
| Ethylene propylene base polymer | 100* | 100** |
| Talc | 57.5 phr | 60 phr |
| MMT | 2.5 | 0 |
| 90% $Pb_3O_4$ | 5 | 5 |
| Agerite Resin D (TMQ) | 1.5 | 1.5 |
| Tris(2-methoxy ethoxy)(vinylsilane) | 1 | 0 |
| Paraffin Wax | 5 | 0 |
| DCP | 2.5 | 2.5 |
| Zinc oxide | 5 | 5 |
| *Vistalon 722; **Vistalon 2504 | | |

Properties of Examples A and B were determined, and are reproduced in Table 6 below. Aging test standards ANSI S-94-649 (oxidation stability for cable rubber) and ASTM D573 (accelerated oven aging of rubber in air) were used.

TABLE 6

| | Example A | Example B |
|---|---|---|
| Breakdown Strength (kV/mm, measured on 0.3-0.5 mm thick samples, according to ASTM D149 standard) | 228 | 181 |
| Breakdown shape factor (test condition same as above) | 5.9 | 12.3 |
| Resistivity (50 °C) (T Ω m) | 1470 | 2415 |
| Conductivity Temperature Coefficient | 0.11 | 0.062 |
| Space charge - field enhancement factor (17 kV/mm; 1.6mm sample; 60°C; 2°C/mm gradient) | 11% | 12% |
| Relaxation time constant (same condition as above) | 29 | 3780 |
| Mechanical Strength | (Passed) | (Passed) |
| Strain | (Passed) | (Passed) |
| Aging (Strength/Strain) | (Passed) | (Passed) |
| Thermal Conductivity | 0.29-0.31 | 0.26-0.28 |
| Dielectric Constant | 2.7 - 2.9 | 2.4-2.6 |
| Dielectric Loss (100 Hz, -40 - 120 C) | <0.04 | <0.01 |
| Conductivity: Field Coefficient | 0.1 mm/kV | 0.028 mm/kV |

As shown in the space charge row above, the difference between Example A and Example B is that for Example

A, the addition of MMT reduces the relaxation time constant. The importance of this is that for the HVDC systems with line-commutated converters (LCC systems), the polarity of the voltage is reversed back and force, and the transition time from one polarity to the other is typically several minutes. If the relaxation time is faster than this transition time, then the space charge can follow the change of voltage and hence minimize the electric field enhancement during the voltage polarity reversal process.

Comparative space charge performance testing was conducted for Examples A and B above, as well as for a comparative unfilled EPR (lacking MMT and talc) and a state-of-the-art extruded DC cable insulation (Superclean DC XLPE Insulation) using pulsed electroacoustic method; applied field: 17 kV/mm; sample thickness: 1.6mm sample; temperature: 60°C; thermal gradient across sample: 2°C/mm). Results are summarized in Table 7 below. This test condition represents the typical operating condition in a cable in terms of electric field level and temperature gradient.

TABLE 7

| Formulation | Field enhancement factor (FEF) | Relaxation time (seconds) |
|---|---|---|
| Superclean™ DC XLPE insulation | 66% | 960 |
| Unfilled EPR | 81% | 7600 |
| Nanofilled EPR, example A | 11% | 29 |
| Nanofilled EPR, example B | 12% | 3780 |

As shown above, for the state-of-the-art XLPE and the unfilled EPR, the FEF is high. Inventive Example A advantageously had considerably decreased relaxation time as compared to comparative Example B.

While additional thermal treatment could reduce the field enhancement factor of the Superclean DC XLPE, if this were to be implemented on cables, it would take several weeks to finish the degassing. On the other hand, the data above were measured on samples without any degassing. The polymer pellets were pressed at 160 deg C for 15 min, and then taken out, and then measured without any additional thermal treatment. A benefit of the present invention is that the low field enhancement factors can be achieved in the absence of any degassing. Furthermore, it has advantageously been found that the addition of MMT significantly shortens the relaxation time.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprise" (and any form of comprise, such as "comprises" and "comprising"), "have" (and any form of have, such as "has" and "having"), "include" (and any form of include, such as "includes" and "including"), "contain" (and any form contain, such as "contains" and "containing"), and any other grammatical variant thereof, are open-ended linking verbs. As a result, a method or device that "comprises", "has", "includes" or "contains" one or more steps or elements possesses those one or more steps or elements, but is not limited to possessing only those one or more steps or elements. Likewise, a step of a method or an element of a device that "comprises", "has", "includes" or "contains" one or more features possesses those one or more features, but is not limited to possessing only those one or more features.

As used herein, the terms "comprising," "has," "including," "containing," and other grammatical variants thereof encompass the terms "consisting of" and "consisting essentially of."

The phrase "consisting essentially of" or grammatical variants thereof when used herein are to be taken as specifying the stated features, integers, steps or components but do not preclude the addition of one or more additional features, integers, steps, components or groups thereof but only if the additional features, integers, steps, components or groups thereof do not materially alter the basic and novel characteristics of the claimed composition, device or method.

All publications cited in this specification are herein incorporated by reference as if each individual publication were specifically and individually indicated to be incorporated by reference herein as though fully set forth.

Subject matter incorporated by reference is not considered to be an alternative to any claim limitations, unless otherwise explicitly indicated.

Where one or more ranges are referred to throughout this specification, each range is intended to be a shorthand format for presenting information, where the range is understood to encompass each discrete point within the range as if the same were fully set forth herein.

While several aspects and embodiments of the present invention have been described and depicted herein, alternative aspects and embodiments may be affected by those skilled in the art to accomplish the same objectives. Accordingly, this disclosure and the appended claims are intended to cover all such further and alternative aspects and embodiments as fall within the true spirit and scope of the invention.

## Claims

1. A high voltage direct current (HVDC) cable (10) with improved electric field distribution, the cable comprising a conductor (12), outer layers (16), and an insulation layer (14) disposed inside the outer layers (16), surrounding the conductor (12), said insulation layer (14) comprising ethylene-propylene rubber, talc, and montmorillonite.

2. An HVDC cable (10) according to claim 1, wherein the outer layers (16) include a protective jacket and a shield layer disposed inside the jacket, and wherein the insulation layer (14) is disposed inside the shield layer.

3. An HVDC cable (10) according to claim 1 or claim 2, wherein the montmorillonite comprises montmorillonite that has been modified with a quaternary ammonium compound.

4. An HVDC cable (10) according to any preceding claim, wherein the montmorillonite comprises at least one of:

   - montmorillonite modified with dimethyl, benzyl, hydrogenated tallow, quaternary ammonium; and
   - montmorillonite modified with dimethyl, dehydrogenated tallow, quaternary ammonium.

5. An HVDC cable (10) according to any preceding claim, wherein the montmorillonite and/or the talc are present in the form of a plurality of particles, said particles having an average particle size of about 10 nm to about 1 mm.

6. An HVDC cable (10) according to any preceding claim, wherein the insulation layer (14) comprises about 0.05 phr to about 30 phr montmorillonite, and more preferably about 0.5 phr to about 10 phr montmorillonite.

7. An HVDC cable (10) according to any preceding claim, wherein the insulation layer (14) comprises about 1 phr to about 100 phr talc, and more preferably about 10 phr to about 60 phr talc.

8. An HVDC cable (10) according to any preceding claim, wherein the insulation layer (14) further comprises a vinyl silane.

9. An HVDC cable (10) according to claim 8, wherein the insulation layer (14) comprises about 0 to about 10 phr vinly silane, and more preferably less than or equal to about 2 phr vinyl silane.

10. An HVDC cable (10) according to claim 8 or claim 9, wherein the vinyl silane is tris (2-methoxyethoxy)(vinyl)silane.

11. An HVDC cable (10) according to any preceding claim, wherein the insulation layer (14) further comprises a processing aid.

12. An HVDC cable (10) according to claim 11, wherein the processing aid comprises low density polyethylene (LDPE) and wax.

13. An HVDC cable (10) according to claim 12, wherein the insulation layer (14) comprises about 0 phr to about 15 phr LDPE and about 0 phr to about 15 phr wax.

14. An HVDC cable (10) according to any preceding claim, wherein the insulation layer (14) further comprises one or more of kaolin, a cross-linking agent, zinc oxide, red lead, and an antioxident.

15. HVDC cable insulation comprising ethylene-propylene rubber, talc, and montmorillonite.

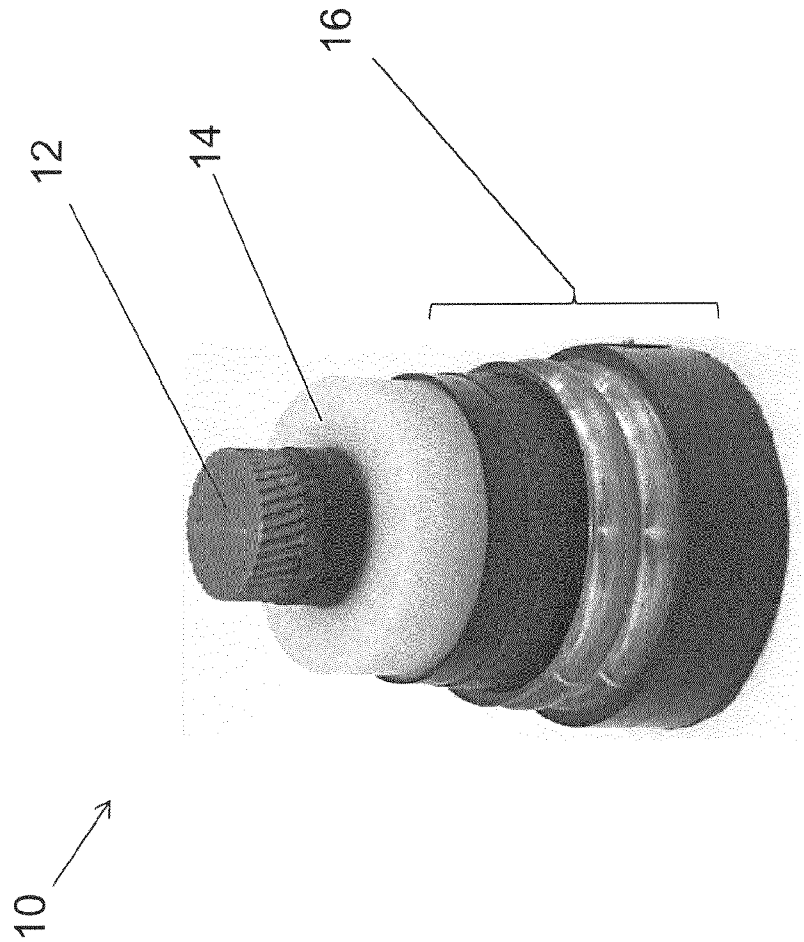


FIG. 1

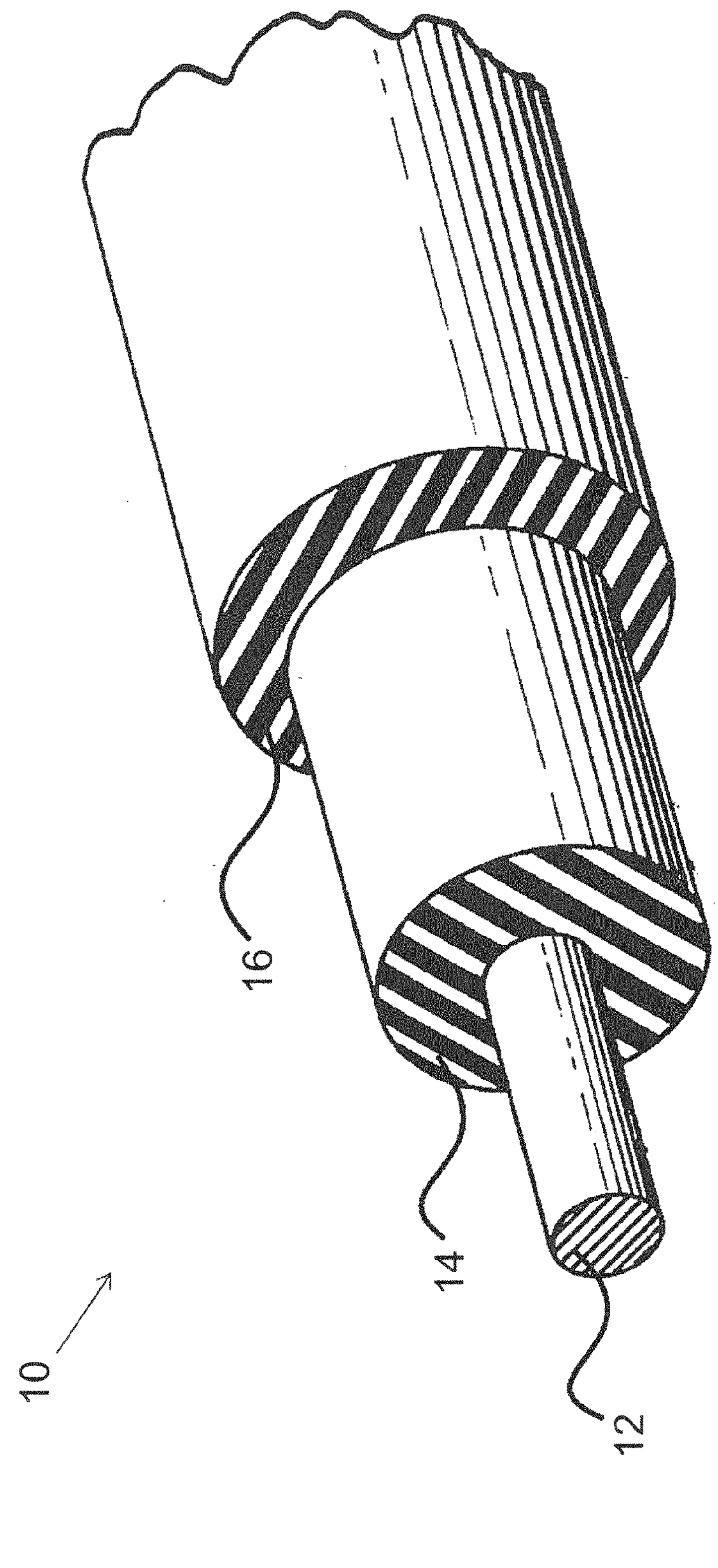


FIG. 2

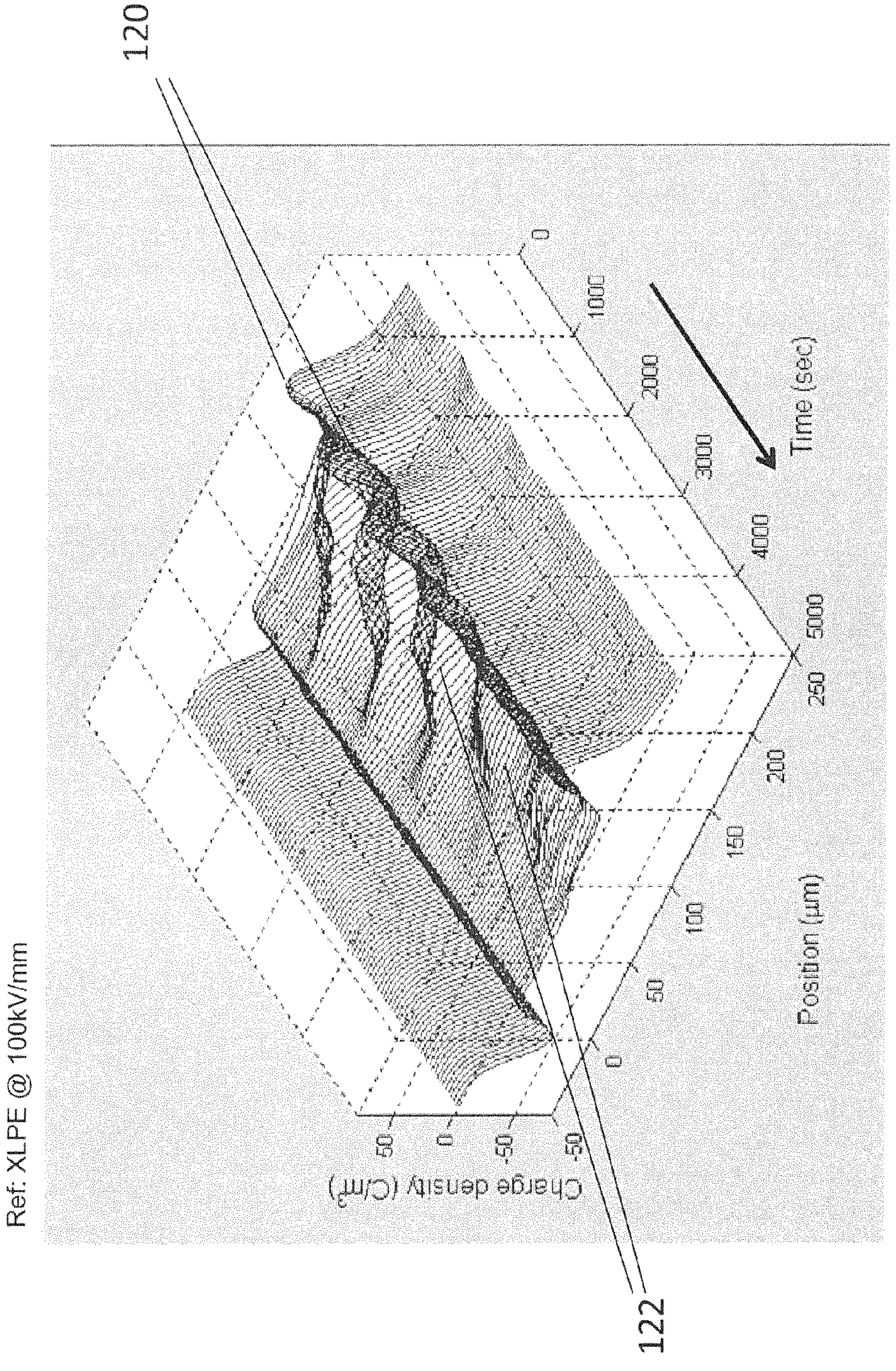
120
122
Ref. XLPE @ 100kV/mm
Charge density (C/m³)
Position (µm)
Time (sec)

FIG. 3A

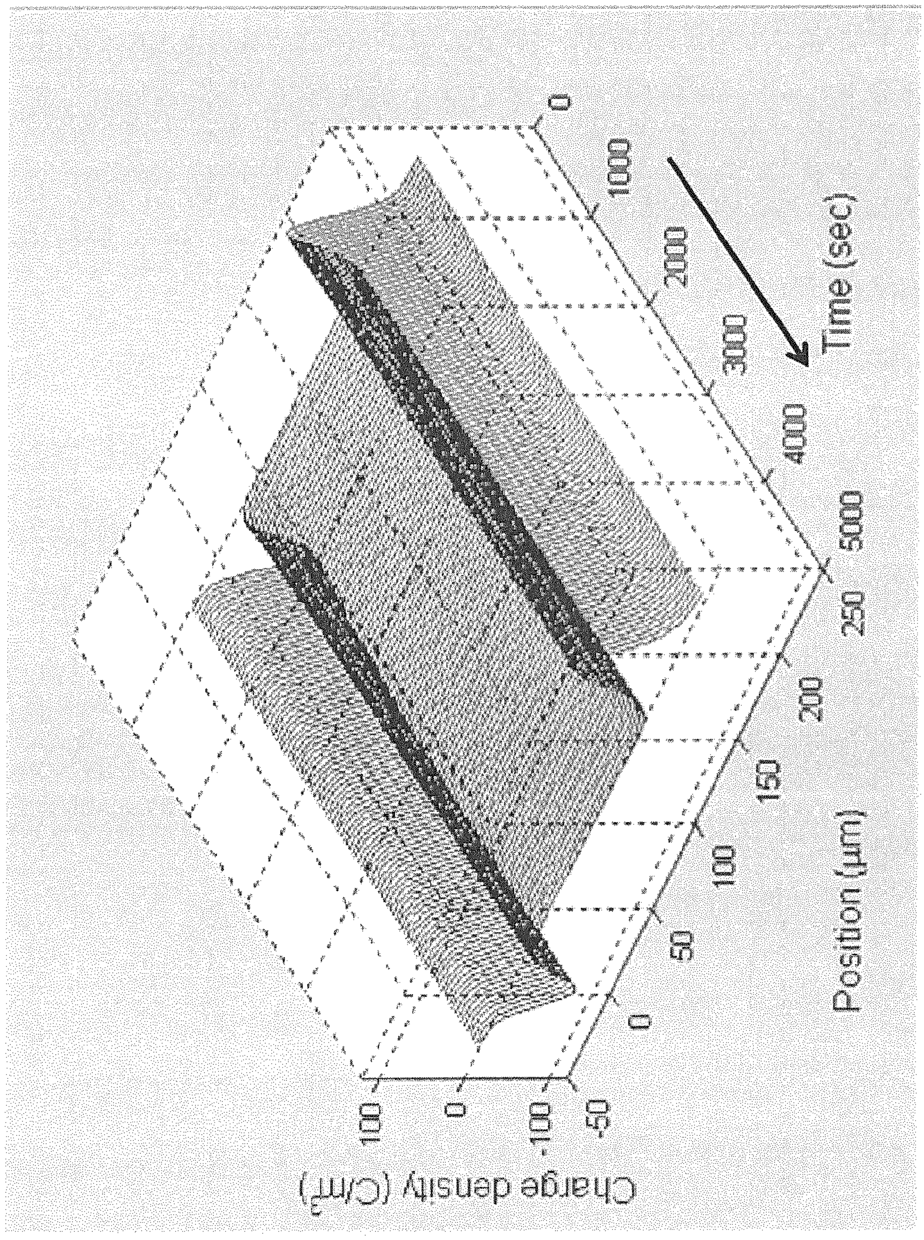
Charge density (C/m³)
100
0
-100
-50
Position (µm)
0
50
100
150
200
250
Time (sec)
0
1000
2000
3000
4000
5000

FIG. 3B

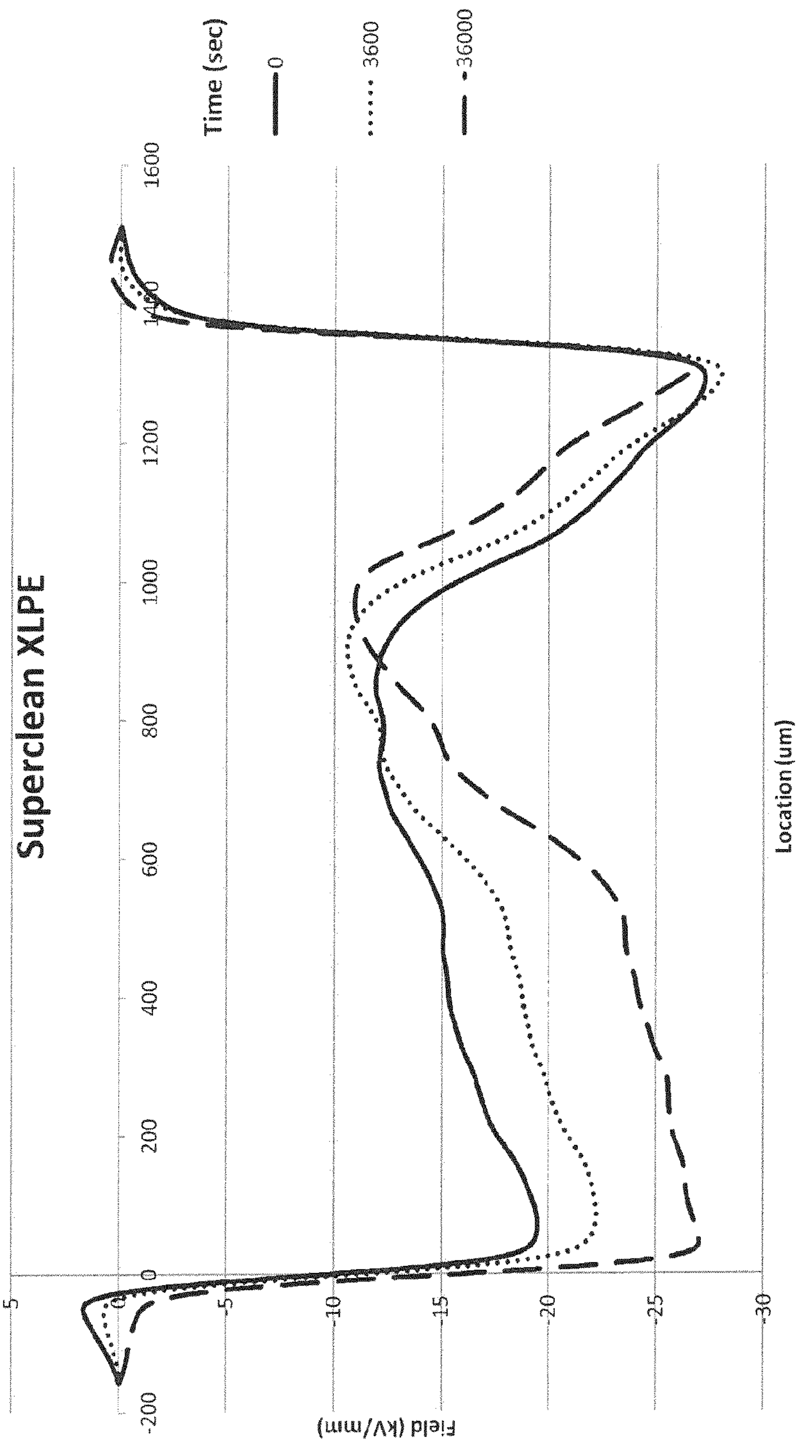
Superclean XLPE
Time (sec)
0
3600
36000
Field (kV/mm)
Location (um)
5
0
-5
-10
-15
-20
-25
-30
-200
0
200
400
600
800
1000
1200
1400
1600

FIG. 4A

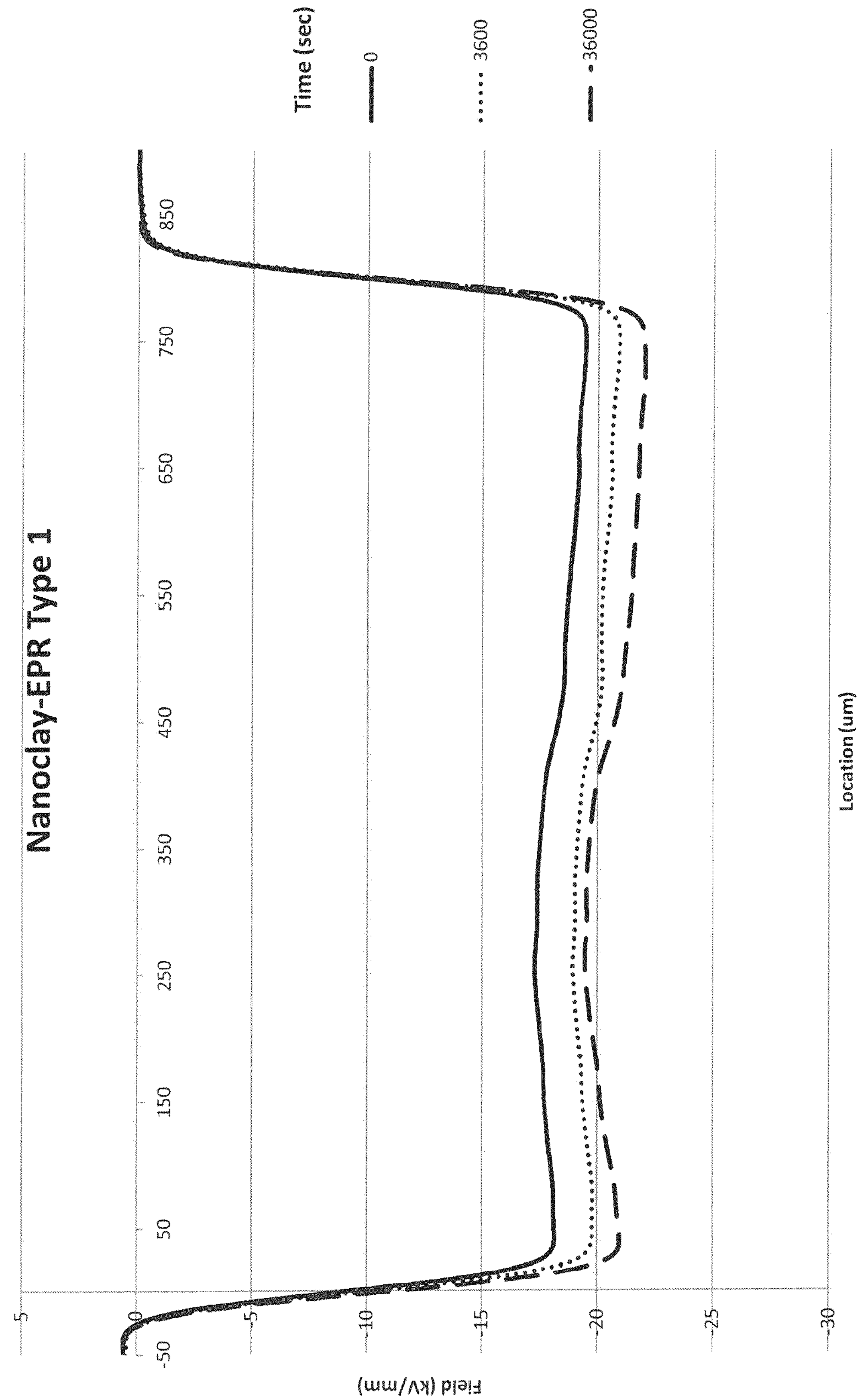
Nanoclay-EPR Type 1
Time (sec)
0
3600
36000
Field (kV/mm)
5
0
-5
-10
-15
-20
-25
-30
-50
50
150
250
350
450
550
650
750
850
Location (um)

FIG. 4B

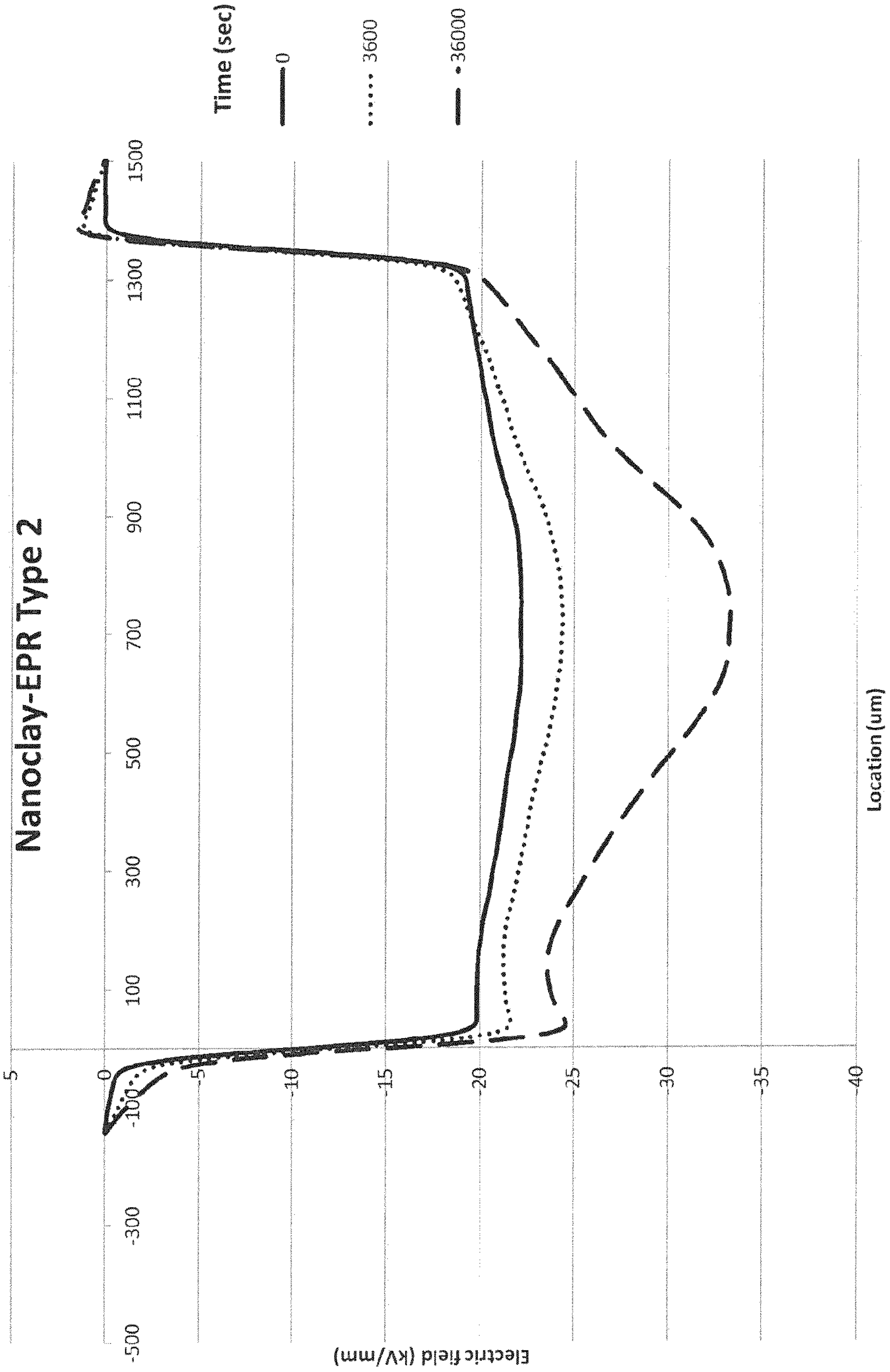
Nanoclay-EPR Type 2
Time (sec)
0
3600
36000
Electric field (kV/mm)
Location (um)
5
0
-5
-10
-15
-20
-25
-30
-35
-40
-500
-300
-100
100
300
500
700
900
1100
1300
1500

FIG. 4C

Europäisches Patentamt
European Patent Office
Office européen des brevets

# EUROPEAN SEARCH REPORT

Application Number
EP 15 18 8104

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/100675 A1 (PERSON TIMOTHY J [US] ET AL) 5 May 2011 (2011-05-05)<br>* paragraph [0003]; claims 1-49; table 1 *<br>* paragraph [0023] *<br>* paragraph [0027] *<br>----- | 1-15 | INV.<br>H01B3/28<br>C08L23/16<br>H01B3/44<br>C08K3/34 |
| X | US 2011/290527 A1 (HILLS CHARLES W [US]) 1 December 2011 (2011-12-01)<br>* paragraph [0016] - paragraph [0022]; claims 1-20 *<br>* paragraph [0031] *<br>----- | 1,15 | |
| | | | TECHNICAL FIELDS SEARCHED (IPC) |
| | | | H01B<br>C08L<br>C08K |

The present search report has been drawn up for all claims

1

| Place of search | Date of completion of the search | Examiner |
|---|---|---|
| The Hague | 3 December 2015 | Mehdaoui, Imed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 15 18 8104

This annex lists the patent family members relating to the patent documents cited in the above-mentioned European search report. The members are as contained in the European Patent Office EDP file on
The European Patent Office is in no way liable for these particulars which are merely given for the purpose of information.

03-12-2015

| Patent document cited in search report | Publication date | Patent family member(s) | Publication date |
|---|---|---|---|
| US 2011100675 A1 | 05-05-2011 | AT 541890 T | 15-02-2012 |
| | | CA 2703974 A1 | 07-05-2009 |
| | | CN 101918486 A | 15-12-2010 |
| | | EP 2215158 A1 | 11-08-2010 |
| | | JP 5473926 B2 | 16-04-2014 |
| | | JP 2011503784 A | 27-01-2011 |
| | | KR 20100099688 A | 13-09-2010 |
| | | TW 200936665 A | 01-09-2009 |
| | | US 2011100675 A1 | 05-05-2011 |
| | | WO 2009058560 A1 | 07-05-2009 |
| US 2011290527 A1 | 01-12-2011 | AR 081921 A1 | 31-10-2012 |
| | | AU 2011258840 A1 | 06-12-2012 |
| | | CA 2800871 A1 | 01-12-2011 |
| | | CL 2012003327 A1 | 08-03-2013 |
| | | EP 2576730 A2 | 10-04-2013 |
| | | JP 2013527298 A | 27-06-2013 |
| | | JP 2015091951 A | 14-05-2015 |
| | | KR 20130053415 A | 23-05-2013 |
| | | US 2011290527 A1 | 01-12-2011 |
| | | WO 2011149591 A2 | 01-12-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 8308506 B